# EUROPEAN PATENT APPLICATION

(11) **EP 4 372 827 A1**
(43) Date of publication of application: **22.05.2024**
(21) Application number: 22207863.6
(22) Date of filing: 16.11.2022
(51) Int. Cl.: H01L 31/0224, H01L 31/05

(54) **SOLAR CELL MODULE**

(71) Applicant: Meyer Burger AG, 3645 GWATT (Thun) (CH)
(72) Inventor: LÜDI, Dominik, 3645 Gwatt (Thun) (CH); RATH, Christian, 3645 Gwatt (Thun) (CH)
(74) Representative: Kraus & Lederer PartGmbB

(57) **Abstract**

Examples disclose a solar cell module (100) comprising a first solar cell string unit (161), a second solar cell string unit (162), a third solar cell string unit (163) and a fourth solar cell string unit (164) which are advantageously interconnected.

## Description

The disclosure relates to a solar cell module. A solar cell module may also be called a photovoltaic module.

WO 2015/001413 A1 discloses a solar cell module, sometimes also called photovoltaic module, comprising several solar cell strings, wherein each solar cell string comprises several solar cells connected in series. The solar cells are arranged between a front side encapsulation layer and a back side encapsulation layer.

There may be a need for new arrangements of solar cells in a solar cell module to reduce the risk of hot spots and being compatible with standard solar cell module sizes.

Said need has been addressed with the subject-matter of the independent claims. Advantageous embodiments are described in the dependent claims.

Examples disclose a solar cell module comprising a first solar cell string unit, a first by-pass connector, a first interconnector, a second interconnector, and a first by-pass element. The first by-pass connector is arranged parallel to, in particular lateral to, the first cell string unit. The first interconnector is mechanically and electrically connected to a first end contact of the first solar cell string unit. The first by-pass element electrically connects the first interconnector to a first end contact of the first by-pass connector. A second end contact of the first by-pass connector is arranged at a side of the first solar cell string unit opposite to the first interconnector. A second end contact of the first solar cell string unit and the second end contact of the first by-pass connector are mechanically and electrically connected by the second interconnector.

The solar cell module further comprises a second solar cell string unit, a third interconnector, a fourth interconnector, and a second by-pass element. The second solar cell string unit is arranged anti-parallel to, in particular lateral to, the first solar cell string unit. The first by-pass connector is arranged between the first solar cell string unit and the second solar cell string unit. A first end contact of the second solar cell string unit is mechanically and electrically connected to the fourth interconnector. A second end contact of the second solar cell string unit and the second end contact of the first by-pass connector are mechanically and electrically connected to the third interconnector. The second by-pass element electrically connects the second end contact of the first by-pass connector to the fourth interconnector.

In addition, the solar cell module comprises a third solar cell string unit, a fifth interconnector, a sixth interconnector; a second by-pass connector; and a third by-pass element. The third solar cell string unit is arranged in prolongation of the second solar cell string unit. The second by-pass connector is arranged parallel to, in particular lateral to, the third cell string unit, in particular in prolongation of the first by-pass connector. The fifth interconnector is mechanically and electrically connected to a first end contact of the third solar cell string unit. The third by-pass element electrically connects the fifth interconnector to a first end contact of the second by-pass connector. A second end contact of the second by-pass connector is arranged at a side of the third solar cell string unit opposite to the fifth interconnector. A second end contact of the third solar cell string unit and the second end contact of the second by-pass connector are mechanically and electrically connected by the sixth interconnector.

The solar cell module further includes a fourth solar cell string unit; a seventh interconnector; an eighth interconnector; and a fourth by-pass element. The fourth solar cell string unit is arranged in prolongation of the first solar cell string unit, in particular anti-parallel and/or lateral to the third solar cell string unit. The second by-pass connector is arranged between the third solar cell string unit and the fourth solar cell string unit. A first end contact of the fourth solar cell string unit is mechanically and electrically connected to the eighth interconnector. A second end contact of the fourth solar cell string unit and the second end contact of the second by-pass connector are mechanically and electrically connected to the seventh interconnector. The fourth by-pass element electrically connects the second end contact of the second by-pass connector to the eighth interconnector.

In some examples, the third interconnector is the second interconnector. Thus, a single interconnector may be used for providing the mechanical and electrical contacts instead of two separate interconnectors. The third interconnector and the second interconnector may be one common piece.

According to some examples, the fifth interconnector is the fourth interconnector. Hence, a single interconnector may be used for providing the mechanical and electrical contacts instead of two separate interconnectors. The fifth interconnector and the fourth interconnector may be one common piece.

Some examples may prescribe that the seventh interconnector is the sixth interconnector. Accordingly, a single interconnector may be used for providing the mechanical and electrical contacts instead of two separate interconnectors. The seventh interconnector and the sixth interconnector may be one common piece.

In some examples, the first solar cell string unit, the second solar cell string unit, the third solar cell string unit and the fourth solar cell string unit each comprise the same number of solar cell strings and at least two solar cell strings. In particular, each solar string unit may comprise at least three solar cell strings. More particularly, each solar string may comprise exactly three solar cell strings.

According to examples each solar cell string comprises at least two solar cells. Preferably, each solar cell string comprises twelve or more solar cells, in particular exactly twelve solar cells. Using twelve solar cells may provide a good compromise with respect to the voltage provided by the solar cell string and the physical size of the solar cell string.

Some examples may prescribe that the solar cells are third cells, half cells or full cells. In some examples, the width of the solar cells may be three times the length of the solar cells. In other examples, the width of the solar cells may be two times the length of the solar cells. It is also possible that the width of the solar cells is the same as the length of the solar cells. The width may describe the dimension of the solar cell in a direction perpendicular to the direction of the solar cell string. Using solar cells with a higher width with respect to the length may allow for solar cell strings comprising more solar cells for a given outer dimension of the solar cell module. Thus, each solar cell string may provide a higher voltage for a given width of the solar cell string.

The solar cell module may be a bifacial solar cell module.

In examples, at least one of the first by-pass element, the second by-pass element, the third by-pass element and/or the fourth by-pass element comprises a diode.

According to further examples, the solar cell module further comprises a junction box; wherein at least one of the first by-pass element, the second by-pass element, the third by-pass element and/or the fourth by-pass element is arranged in the junction box.

The first solar cell string unit, the second solar cell string unit, the third solar cell string unit, and the fourth solar cell string unit may be electrically connected in series.

The junction box may be arranged between the first solar cell string unit and the fourth solar cell string unit and/or the second solar cell string unit.

Examples of the proposed solar cell module are described with respect to the drawing in which:
- Fig. 1: illustrates a solar cell module;
- Fig. 2: shows a solar cell string;
- Fig. 3: shows a solar cell string; and
- Fig. 4: shows a portion of a solar cell module.

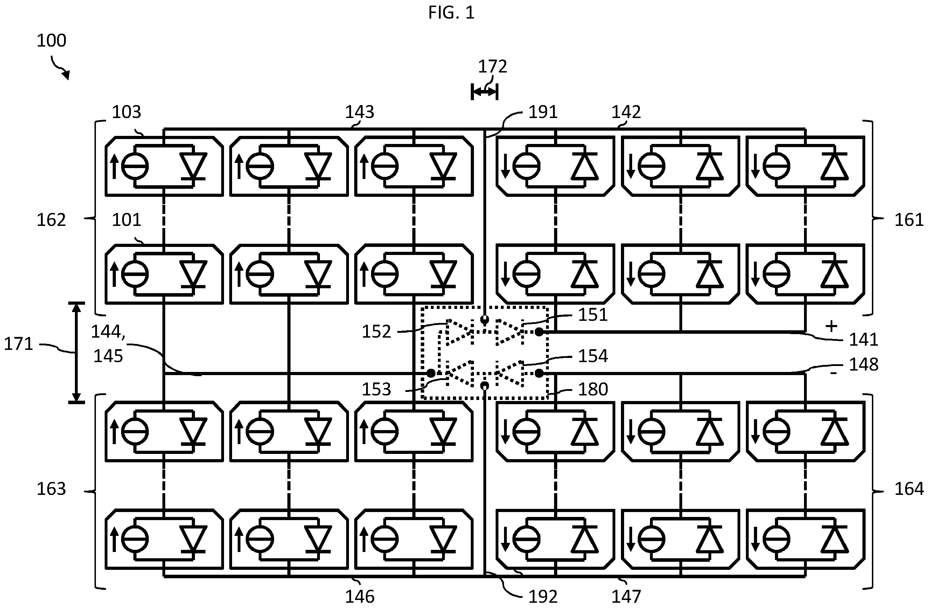

Fig. 1 shows a solar cell module 100. In particular, Fig. 1 schematically illustrates the electrical circuit of the solar cell module 100 and the arrangement of the solar cells 101, ..., 103, etc. of the solar cell module 100, when looking on a front side of the solar cell module 100.

The solar cell module 100 comprises a first solar cell string unit 161, a second solar cell string unit 162, a third solar cell string unit 163, and a fourth solar cell string unit 164. Each solar cell string unit 161, 162, 163, 164 may comprise the same number of solar cell strings electrically connected in parallel, in particular each solar cell string unit 161, 162, 163, 164 may comprise at least two solar cell strings. In the example shown in Fig. 1 each solar cell string unit 161, 162, 163, 164 consists of three solar cell strings connected in parallel. In practice, parts of the solar cell module 100 may be shaded. For example, parts of the solar cell module 100 may be covered with snow, dirt, leaves, etc. Thus, light may not reach a particular solar cell which will not generate any current. However, the neighboring solar cells will continue to generate current, setting the shaded solar cell under tension and generating a hot spot which may finally result in a damaged solar cell and, thus, a damaged solar cell module. By-pass elements 151, 152, 153, 154 may allow current to by-pass the (partially) shaded solar cells and limit the voltage and the current the (partially) shaded solar cell(s) experience. Due to the usage of more by-pass elements than in typical photovoltaic modules, the amount of solar cells which have to be supported by a by-pass element may be reduced. Moreover, the solar cell module 100 comprises four by-pass elements 151, 152, 153, 154. Hence, a smaller number of solar cells may be by-passed in case of partial shading. This may further increase the energy yield of the solar cell module. Additionally, this may reduce the hotspot temperature in case of partial shading of the module and thus, reduce the probability of the hotspot damaging the module. Using three solar cell strings for each solar cell string unit 161, 162, 163, 164 may result in advantageous outer dimensions of the solar cell module 100. One solar cell string may comprise at least two solar cells 101, 103 electrically connected in series. In particular, each solar cell string may consist of ten, eleven or twelve solar cells electrically connected in series. Half cells may lead to reduced power losses. However, it is also conceivable to use full cells for the solar cell strings. The solar cells may be M10 full cells or M10 half-cut cells or M12 third-cut cells.

A first by-pass connector 191 is arranged parallel to the first cell string unit 161. In particular, the first by-pass connector 191 may be arranged laterally to the first cell string unit 161. A first interconnector 141 is mechanically and electrically connected to first ends of the first solar cell string unit 161. In some examples, the first end contacts of the first solar cell string 161 are welded or soldered to the first interconnector 141. A first by-pass element 151 electrically connects the first interconnector 141 to a first end contact of the first by-pass connector 191. A second end contact of the first by-pass connector 191 is arranged at a side of the first solar cell string unit 161 opposite to the first interconnector 141. As shown in Fig. 1, the first interconnector 141 may be arranged horizontally and the first by-pass connector 191 may be arranged vertically.

A second interconnector 142 and a second end contact of the first by-pass connector 191 are mechanically and electrically connected to second ends of the first solar cell string unit 161. For example, the second interconnector 142 may be welded or soldered to the second ends of the first solar cell string unit 161. The second interconnector 142 may be arranged horizontally, too.

The first by-pass element 151 and the first by-pass connector 191 may allow for by-passing the first solar cell string unit 161 in case current generation by the first solar cell string unit 161 is impeded, for example, due to (partial) shading of the first solar cell string unit 161. Thus, the solar cell module 100 may still generate electricity by means of the other solar cell string units 162, 163, 164.

The second solar cell string unit 162 may be arranged anti-parallel to the first solar cell string unit 161. In particular, the second solar cell string unit 162 may be arranged lateral to the first solar cell string unit 161. The by-pass connector 191 may be arranged between the first solar cell string unit 161 and the second solar cell string unit 162.

First end contacts of the second solar cell string unit 162 may be mechanically and electrically connected to a fourth interconnector 144 (e.g., by welding or soldering). Second end contacts of the second solar cell string unit 162 and the second end contact of the first by-pass connector 191 may be mechanically and electrically connected to a third interconnector 143. A second by-pass element 152 electrically connects the first end contact of the first by-pass connector 191 to the fourth interconnector 144.

The third interconnector 143 may be the first interconnector 142. A single interconnector 142, 143 may be used for mechanically and electrically contacting the second end contacts of the second solar cell string unit 162, the second end contacts of the first solar cell string unit 161 and the second end contact of the first by-pass connector 191. The third interconnector 143 and the second interconnector 142 may be one common piece.

The third solar cell string unit 163 may be arranged in prolongation of the second solar cell string unit 162. The third solar cell string unit 163 and the second solar cell string unit 162 may be arranged in a row. The third solar cell string unit 163 and the second solar cell string unit 162 may be arranged such that current generated by the third solar cell string unit 163 and the second solar cell string unit 162 flows in the same direction. In the example shown in Fig. 1, current generated by the second solar cell string unit 162 flows to the top and current generated by the third solar cell string unit 163 flows to the top.

A fifth interconnector 145 is mechanically and electrically connected to first ends of the third solar cell string unit 163. In the example of Fig. 1, the fifth interconnector is identical to the fourth interconnector 144. However, it is also conceivable that the fifth interconnector 145 is different from the fourth interconnector. The fifth interconnector and the fourth interconnector may be provided separately. In particular, in some examples there may be no direct electrical connection between the fifth interconnector and the fourth interconnector. For example, in case a solar cell module may comprises more than four solar cell string units. Such additional pairs of solar cell string units could be provided left of the second solar cell string unit 162 and the third solar cell string unit 163.

A third by-pass element 153 electrically connects the fifth interconnector 145 to a first end contact of the second by-pass connector 192. A second end contact of the second by-pass connector 192 is arranged at a side of the third solar cell string unit 163 opposite to the fifth interconnector 145.

Second end contacts of the third solar cell string unit 163 and the second end contact of a second by-pass connector 192 may be mechanically and electrically connected by a sixth interconnector 146 (e.g., by welding or soldering).

The fourth solar cell string unit 164 may be arranged in prolongation of the first solar cell string unit 161. The fourth solar cell string unit 164 and the first solar cell string unit 161 may be arranged in a row. The fourth solar cell string unit 164 and the first solar cell string unit 161 may be arranged such that current generated by the fourth solar cell string unit 164 and the first solar cell string unit 161 flows in the same direction. The current generated by the fourth solar cell string unit 164 may flow in the opposite direction of the current generated by the third solar cell string unit 163. The fourth solar cell string unit 164 may be arranged anti-parallel to the third solar cell string unit 163.

The second by-pass connector 192 is arranged between the third solar cell string unit 163 and the fourth solar cell string unit 164. First end contacts of the fourth solar cell string unit 164 are mechanically and electrically connected to an eighth interconnector 148. Second end contacts of the fourth solar cell string unit 164 and the second end contact of the second by-pass connector 192 are mechanically and electrically connected to a seventh interconnector 147. A fourth by-pass element 154 electrically connects the second end contact of the second by-pass connector 192 to the eighth interconnector 148.

The solar cell module 100 may comprise a junction box 180. The junction box may be provided on a back-side of the solar cell module 100. The junction box may be arranged between the first solar cell string unit 161 (second solar cell string unit 162) and the fourth solar cell string unit 164 (third solar cell string unit 163). The junction box may be arranged in the center of the first solar cell string unit 161, the second solar cell string unit 162, the third solar cell string unit 163, and the fourth solar cell string unit 164.

In some examples, the solar cell module 100 may be a bifacial solar cell module. The aforementioned position of the junction box, may avoid that the junction box shades one of the solar cell string units.

At least one of the first by-pass element 151, the second by-pass element 152, the third by-pass element 153, and the fourth by-pass element 154 may be provided in the junction box 180. In particular, all four by-pass elements 151,152, 153, 154 may be provided in the junction box 180. Cables connecting the solar cell module 100 to an electrical installation may be electrically connected to the eighth interconnector 148 and the second interconnector 141 in the junction box.

As shown in Fig. 1, the first solar cell string unit 161, the second solar cell string unit 162, the third solar cell string unit 163 and the fourth solar cell string unit 164 may be electrically connected in series.

At least one of the first by-pass element 151, the second by-pass element 152, the third by-pass element 153 and the fourth by-pass element 154 may comprise a by-pass diode. However, different by-pass element, which may also be called bridging elements), e.g. active switches, may be used alternatively or in addition.

The solar cell module 100 depicted in Fig. 1 may have a height above 2200 mm, in particular between 2200 mm and 2450 mm, more particularly of around 2272 mm or around 2349 mm or around 2415 mm, not taking into account a frame which may surround the solar cell module 100. This may allow for a distance 171 of more than 25 mm, in particular more than 30 mm, more particularly around 66 mm between the first solar cell string unit 161 (second solar cell string unit 162) and the fourth solar cell string unit 164 (third solar cell string unit 163). Such a distance 171 may be sufficient to completely accommodate a junction box. Keeping the distance 171 below 80 mm, in particular below 40 mm may allow for a solar cell module being compatible with standard sizes. A distance between the pluralities of solar cell strings of the solar cell string units 161, 162, 163, 164 may amount to less than 3 mm, in particular around 1.4 mm may allow for providing a solar cell module 100 having a width comparable to standard solar cell module widths. For example, the solar cell module 100 may have a width between 1100 and 1150 mm, in particular between 1120 and 1140 mm, more particularly of around 1136.6 mm. The distance 172 between the first solar cell string unit 161 (fourth solar cell string unit 164) and the second solar cell string unit 162 (third solar cell string unit 163) may be between 8 and 12 mm, in particular around 10 mm. Such a distance may be sufficient to accommodate the first by-pass connector 191 (second by-pass connector 192).

The solar cell module 100 may be implemented with a total number of 132 individual solar cells corresponding to 33 solar cells for each solar cell string unit and 11 solar cells for each solar cell string if three solar cell strings are used per solar cell string unit. The solar cell module 100 may also be implemented with a total number of 144 individual solar cells corresponding to 36 solar cells for each solar cell string unit and 12 solar cells for each solar cell string if three solar cell strings are used per solar cell string unit.

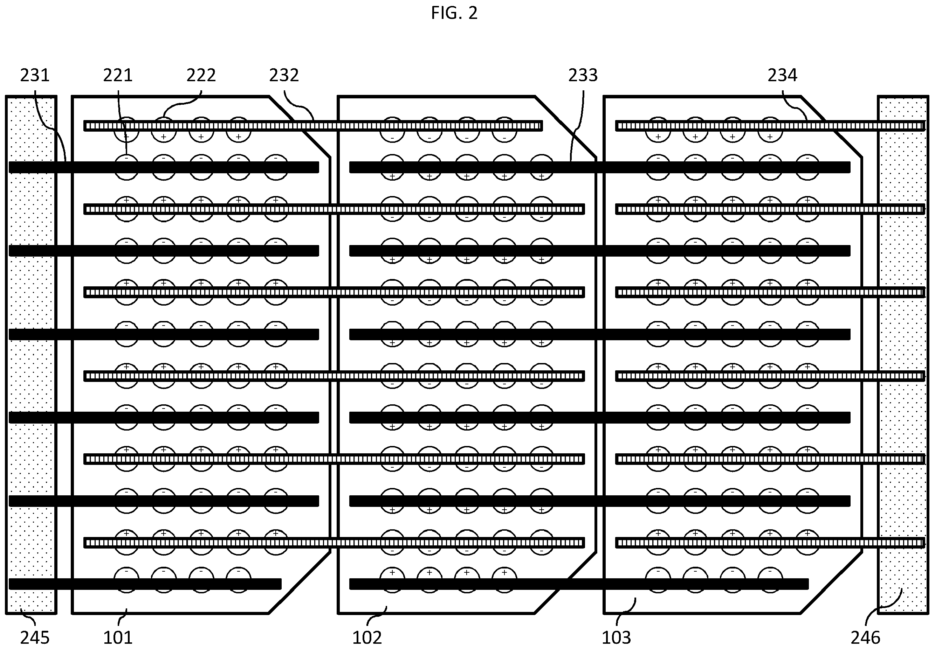

Fig. 2 illustrates a solar cell string comprising the solar cells 101, 102, 103 which may be used for the second solar cell string unit 162 shown in Fig. 1. The solar cell string is shown from the backside of the solar cell module 100. The solar cells 101, 102, 103 include solar cell contacts 221 having a first polarity, e.g. minus or plus, and solar cell contacts 222 having a second polarity, e.g. plus or minus, respectively.

The solar cell string comprises a first plurality of parallel connecting wires 231 having a contacting portion electrically contacting the solar cell contacts 221 having the first polarity of the solar cell 101 and a second plurality of parallel connecting wires 232 electrically contacting the solar cell contacts 222 having the second polarity of the solar cell 101. The connecting wires 231 may have an elliptic cross section, in particular circular cross section. In other examples, the connecting wire may have a rectangular cross section. For examples, the connecting wire may include a connecting tab and/or a flat connector.

An interconnector 245 is provided having a collecting portion crossing the first plurality of parallel connecting wires 231 and electrically contacting the first plurality of parallel connecting wires 231.

The second plurality of parallel connecting wires 232 electrically contacts solar cell contacts of the solar cell 102 having the first polarity. Thus, the second plurality of parallel connecting wires 232 electrically connects the solar cell 101 and the solar cell 102 in series. Similarly, further pluralities of parallel connecting wires 233, 234 connect the solar cell 102 and the solar cell 103 in series and connect the solar cell 103 to the interconnector 246.

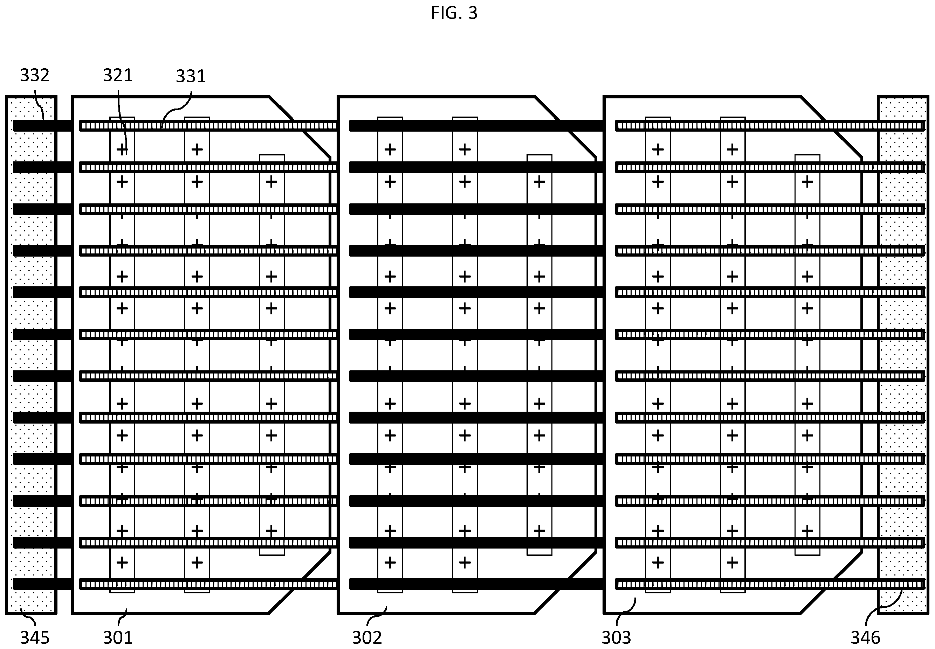

Fig. 3 illustrates another solar cell string comprising solar cells 301, 302, 303 which solar cell string may form part of the second solar cell string unit 162. The solar cell string is shown from the backside of the solar cell module. The solar cells 301, 302, 303 include solar cell contacts 321 having a first polarity, e.g. plus or minus, and solar cell contacts having a second polarity, e.g. minus or plus, respectively The solar cell contacts having the second polarity are provided behind the solar cells 301, 302, 303 shown in Fig. 3.

The solar cell string comprises a plurality of parallel connecting wires 331 having a contacting portion electrically contacting the solar cell contacts 321 having the first polarity of the solar cell 301 and the solar cell contacts having the second polarity of the solar cell 302.

An interconnector 345 is provided having a collecting portion crossing a plurality of parallel connecting wires 332 and electrically contacting the plurality of parallel connecting wires 332.

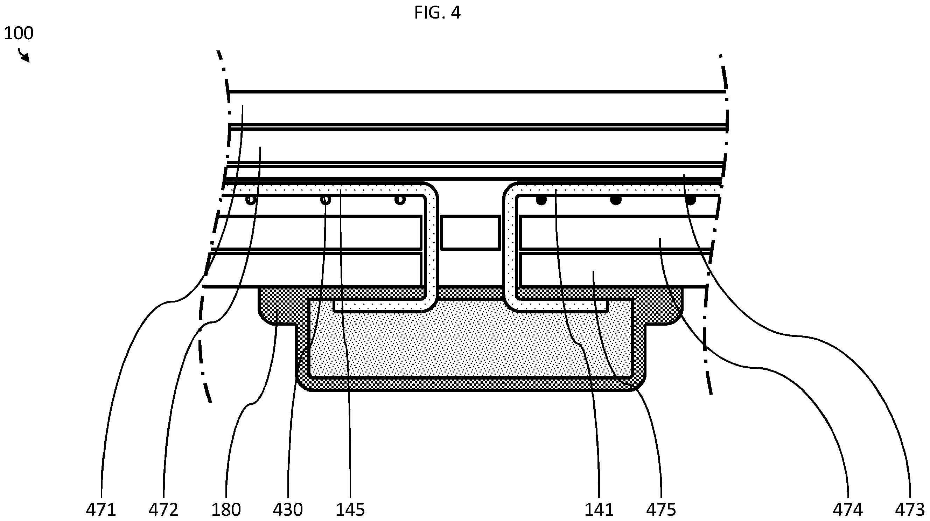

Fig. 4 shows a portion of a solar cell module 100 with the interconnectors 145, 141 in a cross-sectional view. The solar cell string units 161, 162, 163, 164, the connecting wires 430 connecting the individual solar cell of the solar cell string units to each other, the interconnectors (e.g., the interconnectors 145, 144) as well as the by-pass connectors may have to be protected from the environment to avoid degradation and damage. Typically, they are encapsulated in a solar cell module laminate shown in Fig. 4. The solar cell string units 161, 162, 163, 164 are arranged between a front side encapsulation layer 472 and a back side encapsulation layer 474. A front glass 471 and a back glass (or, alternatively, a back sheet) 475 may be arranged at a front side and a back side of the solar cell module 100. At least one cover strip 473 covering the interconnectors and/or the by-pass connectors may be provided to render the interconnectors and by-pass connectors invisible from a front side of the solar cell module 100.

As explained hereinbefore, the junction box 180 may be provided at a back side of the solar cell module 100, in particular at a back side of the back glass (or back sheet) 475. As the ends of the interconnectors and the by-pass connectors may all be provided in a central region in the center of the solar cell string units 161, 162, 163, 164, through holes for passing said ends through the back side encapsulation layer 474 and the back glass (or back sheet) 475 may only have to be provided in said region. The junction box 180 may cover said through holes and provide additional protections such that, e.g., moisture does not enter into the laminate of the solar cell module 100. In addition, the provision of all the through holes in the central region may allow for using a smaller junction box 180.

Summarizing, examples disclose a solar cell module 100 comprising a first solar cell string unit 161, a second solar cell string unit 162, a third solar cell string unit 163 and a fourth solar cell string unit 164 which are advantageously interconnected.

## Claims

1. Solar cell module (100) comprising
a first solar cell string unit (161),
a first by-pass connector (191),
a first interconnector (141),
a second interconnector (142), and
a first by-pass element (151);
wherein the first by-pass connector (191) is arranged parallel to, in particular lateral to, the first cell string unit (161);
wherein the first interconnector (141) is mechanically and electrically connected to a first end contact of the first solar cell string unit (161), wherein the first by-pass element (151) electrically connects the first interconnector (141) to a first end contact of the first by-pass connector (191); wherein a second end contact of the first by-pass connector (191) is arranged at a side of the first solar cell string unit (161) opposite to the first interconnector (141);
wherein a second end contact of the first solar cell string unit (161) and the second end contact of the first by-pass connector (191) are mechanically and electrically connected by the second interconnector (142);
a second solar cell string unit (162),
a third interconnector (143),
a fourth interconnector (144), and
a second by-pass element (152);
wherein the second solar cell string unit (162) is arranged anti-parallel to, in particular lateral to, the first solar cell string unit (161);
wherein the first by-pass connector (191) is arranged between the first solar cell string unit (161) and the second solar cell string unit (162); wherein a first end contact of the second solar cell string unit (162) is mechanically and electrically connected to the fourth interconnector (144); wherein a second end contact of the second solar cell string unit (162) and the second end contact of the first by-pass connector (191) are mechanically and electrically connected to the third interconnector (143); and wherein the second by-pass element (152) electrically connects the second end contact of the first by-pass connector (191) to the fourth interconnector (144),
a third solar cell string unit (163),
a fifth interconnector (145),
a sixth interconnector (146);
a second by-pass connector (192); and
a third by-pass element (153);
wherein the third solar cell string unit (163) is arranged in prolongation of the second solar cell string unit (162);
wherein the second by-pass connector (192) is arranged parallel to, in particular lateral to, the third cell string unit (163), in particular in prolongation of the first by-pass connector (191);
wherein the fifth interconnector (145) is mechanically and electrically connected to a first end contact of the third solar cell string unit (163), wherein the third by-pass element (153) electrically connects the fifth interconnector (145) to a first end contact of the second by-pass connector (192);
wherein a second end contact of the second by-pass connector (192) is arranged at a side of the third solar cell string unit (163) opposite to the fifth interconnector (145);
wherein a second end contact of the third solar cell string unit (163) and the second end contact of the second by-pass connector (192) are mechanically and electrically connected by the sixth interconnector (146);
a fourth solar cell string unit (164);
a seventh interconnector (147);
an eighth interconnector (148); and
a fourth by-pass element (154);
wherein the fourth solar cell string unit (164) is arranged in prolongation of the first solar cell string unit (161), in particular anti-parallel and/or lateral to the third solar cell string unit (163);
wherein the second by-pass connector (192) is arranged between the third solar cell string unit (163) and the fourth solar cell string unit (164), wherein a first end contact of the fourth solar cell string unit (164) is mechanically and electrically connected to the eighth interconnector (148); wherein a second end contact of the fourth solar cell string unit (164) and the second end contact of the second by-pass connector (192) are mechanically and electrically connected to the seventh interconnector (147); and
wherein the fourth by-pass element (154) electrically connects the second end contact of the second by-pass connector (192) to the eighth interconnector (148).

2. Solar cell module (100) according to claim 1,
wherein the third interconnector (143) is the second interconnector (142).

3. Solar cell module (100) according to claim 1 or 2,
wherein the fifth interconnector (145) is the fourth interconnector (144).

4. Solar cell module (100) according to any one of claims 1 to 3,
wherein the seventh interconnector (147) is the sixth interconnector (146).

5. Solar cell module (100) according to any one of the preceding claims,
wherein the first solar cell string unit (161), the second solar cell string unit (162), the third solar cell string unit (163) and the fourth solar cell string unit (164) each comprise the same number of solar cell strings and at least two solar cell strings, in particular at least three solar cell strings, more particularly exactly three solar cell strings.

6. Solar cell module (100) according to claim 5,
wherein each solar cell string comprises at least two solar cells, in particular twelve solar cells, electrically connected in series.

7. Solar cell module (100) according to claim 6,
wherein the solar cells (101, 102, 103; 301, 302, 303) are third cells, half cells or full cells.

8. Solar cell module (100) according to any one of the preceding claims,
wherein the solar cell module is a bifacial solar cell module.

9. Solar cell module (100) according to any one of the preceding claims,
wherein at least one of the first by-pass element (151), the second by-pass element (152), the third by-pass element (153) and the fourth by-pass element (154) comprises a diode.

10. Solar cell module (100) according to any one of the preceding claims, further comprising
a junction box (180);
wherein at least one of the first by-pass element (151), the second by-pass element (152), the third by-pass element (153) or fourth by-pass element (154) is arranged in the junction box.

11. Solar cell module (100) according to any one of the preceding claims 1 to 10,
wherein the first solar cell string unit (161), the second solar cell string unit (162), the third solar cell string unit (163), and the fourth solar cell string unit (164) are electrically connected in series.

12. Solar cell module (100) according to any one of the preceding claims, wherein the junction box (180) is arranged between the first solar cell string unit (161) and the fourth solar cell string unit (164).and/or the second solar cell string unit (162).
